# EUROPÄISCHE PATENTSCHRIFT

(11) **EP 2 791 954 B1**
(45) Veröffentlichungstag und Bekanntmachung des Hinweises auf die Patenterteilung: **01.03.2017**
(21) Anmeldenummer: 12794648.1
(22) Anmeldetag: 22.10.2012
(51) Int. Cl.: H01H 9/16

(54) **SCHALTUNGSANORDNUNG UND VERFAHREN ZUM ERKENNEN EINER SCHALTERSTELLUNG**
CIRCUIT ARRANGEMENT AND PROCESS FOR DETECTING A SWITCH POSITION
CIRCUIT ET PROCÉDÉ PERMETTANT LA RECONNAISSANCE DE LA POSITION D'UN COMMUTATEUR

(30) Priorität: 13.12.2011 DE 102011088411
(43) Veröffentlichungstag der Anmeldung: 22.10.2014
(73) Patentinhaber: Robert Bosch GmbH, 70442 Stuttgart (DE)
(72) Erfinder: WISZNIEWSKI, Jacek, 70771 Leinfelden-Echterdingen (DE); POGORZELSKI, Kamil, 70176 Stuttgart (DE)
(86) Internationale Anmeldenummer: PCT/EP2012/070855
(87) Internationale Veröffentlichungsnummer: WO 2013/087269

(56) Entgegenhaltungen:
- EP-A1- 0 252 816
- EP-A2- 0 336 051
- DE-A1- 19 817 291
- DE-B3-102006 033 705
- DE-T2- 69 720 816

## Beschreibung

Die Erfindung betrifft eine Schaltungsanordnung zum Erkennen einer Schalterstellung gemäß Patentanspruch 1, sowie ein Elektrogerät mit einer solchen Schaltungsanordnung gemäß Patentanspruch 7.

### Stand der Technik

Es ist bekannt, elektrische Geräte mit Schaltern zu versehen, um die Geräte ein- und auszuschalten. Es sind auch dauerversorgte elektrische Geräte bekannt, die auch in ausgeschaltetem Zustand noch elektrische Energie beziehen. Es ist bekannt, solche elektrischen Geräte mit Vorrichtungen auszustatten, die dazu dienen, eine Schalterstellung des Schalters zu erkennen. Die Erkennung kann beispielsweise indirekt über eine an einem Triac anliegende Spannung oder direkt über ein vom Schalter ausgesandtes Signal erfolgen. Bei all diesen Lösungen sind zum Erkennen der Schalterstellung eigens vorgesehene elektrische und elektronische Bauteile und Komponenten erforderlich. Es ist auch bekannt, Schaltern Widerstände parallel zu schalten, um eine Elektronik dauerhaft zu versorgen, beispielsweise bei Maschinen mit Wiederanlaufschutz und Strombegrenzung am Kohlebürstenapparat.

Die DE 697 20 816 T2 beschreibt ein System zur Überwachung der Zustände von mit einer Wechselspannung verbundenen Schaltern. Das System umfasst eine Mikrosteuervorrichtung mit mehreren Eingängen, welche die Überwachung der Zustände mehrerer Schalter gestattet, die sämtlich eine Wechselspannung zugeführt erhalten.

Die EP 0 336 051 A2 beschreibt eine Schaltungsanordnung mit einem elektromechanischen Programmschaltwerk und einer elektronischen Auswerteschaltung eines Geräts. Die Schaltungsanordnung dient zur leitungsgebundenen Übertragung von Sollwerten entsprechenden Schalterstellungen wenigstens eines an Wechselspannung liegenden Schalters des elektromechanischen Programmschaltwerks.

Die DE 10 2006 033 705 B3 beschreibt eine Schaltungsanordnung zur Überprüfung einer Schalterstellung. Die Anschlüsse eines Schalters werden dabei mit zwei verschiedenen elektrischen Potentialen verbunden, die mittels einer Versorgungsspannung generiert werden. Die an den Schaltungseingängen vorhandenen elektrischen Potentiale hängen von der Position des Schalters ab. Über die an diesen Punkten gemessenen und vorzugsweise digitalisierten Spannungspegel kann die Schalterstellung überprüft werden.

Die EP 0 252 816 A1 beschreibt eine Steuervorrichtung für eine Waschmaschine.

Die DE 198 17 291 A1 beschreibt ein Verfahren zur Ermittlung der Stellung von wenigstens einer an einem Mikrocontroller oder dergleichen angeschlossenen Schalteinrichtung. Dabei gibt der Mikrocontroller wiederholt ein Ausgangssignal an die Schalteinrichtung ab und erfasst daraus resultierend ein Eingangssignal.

### Offenbarung der Erfindung

Die Aufgabe der vorliegenden Erfindung besteht deshalb darin, eine verbesserte Schaltungsanordnung zum Erkennen einer Schalterstellung bereitzustellen. Diese Aufgabe wird durch eine Schaltungsanordnung mit den Merkmalen des Anspruchs 1 gelöst. Es ist weiter Aufgabe der vorliegenden Erfindung, ein Elektrogerät mit einer derartigen Schaltungsanordnung bereitzustellen. Diese Aufgabe wird durch ein Elektrogerät mit den Merkmalen des Anspruchs 7 gelöst. Bevorzugte Weiterbildungen sind in den abhängigen Ansprüchen angegeben.

Eine erfindungsgemäße Schaltungsanordnung zum Erkennen einer Schalterstellung umfasst einen ersten Knoten, der mit einer Phase eines Stromnetzes verbunden werden kann, einen dritten Knoten und einen Mikrocontroller. Dabei ist zwischen dem ersten Knoten und dem dritten Knoten ein Schalter angeordnet. Ein Widerstand ist parallel zu dem Schalter zwischen dem ersten Knoten und dem dritten Knoten angeordnet. Ein Anschluss des Mikrocontrollers ist mit dem dritten Knoten verbunden. Der Mikrocontroller ist programmiert, eine an dem Anschluss anliegende Spannung mit einer Referenzspannung zu vergleichen und anhand dieses Vergleichs festzustellen, ob der Schalter geöffnet oder geschlossen ist. Vorteilhafterweise ist die Erkennung der Schalterstellung bei dieser Schaltungsanordnung durch den Mikrocontroller möglich, ohne dass zusätzliche elektronische Bauelemente vorgesehen werden müssen. Dadurch ist die Schaltungsanordnung vorteilhafterweise besonders kostengünstig herzustellen.

In einer Weiterbildung der Schaltungsanordnung weist der Mikrocontroller einen Analog-Digital-Wandler auf, wobei die Referenzspannung als Bezugswert des Analog-Digital-Wandlers dient. Dabei ist der Mikrocontroller programmiert, die an dem Anschluss anliegende Spannung mittels des Analog-Digital-Wandlers zu digitalisieren, um einen Digitalwert zu erhalten. Dabei ist der Mikrocontroller ferner programmiert, anhand des Digitalwerts festzustellen, ob der Schalter geöffnet oder geschlossen ist. Vorteilhafterweise wird dann ein im Mikrocontroller ohnehin vorhandener Analog-Digital-Wandler zur Erkennung der Schalterstellung genutzt.

Der Anschluss des Mikrocontroller ist ein Spannungsversorgungsanschluss des Mikrocontrollers. Vorteilhafterweise werden zur Erkennung der Schalterstellung keine weiteren Anschlüsse des Mikrocontrollers, insbesondere keine IO-Anschlüsse des Mikrocontrollers benötigt.

Ebenfalls bevorzugt ist, dass die Referenzspannung eine interne Referenzspannung des Mikrocontrollers ist. Vorteilhafterweise ist es dann nicht erforderlich, dem Mikrocontroller die Referenzspannung von außen zuzuführen, wodurch sich der Aufbau der Schaltungsanordnung vereinfacht.

In einer Weiterbildung der Schaltungsanordnung weist diese einen zweiten Knoten auf, der mit einem Neutralleiter eines Stromnetzes verbunden werden kann. Dabei weist die Schaltungsanordnung außerdem einen siebten Knoten auf, der mit einem Massepotential verbunden ist. Dabei ist eine Anode einer Zenerdiode mit dem siebten Knoten und eine Kathode der Zenerdiode mit dem dritten Knoten verbunden. Außerdem ist ein Kondensator zwischen dem dritten Knoten und dem siebten Knoten angeordnet. Weiter ist ein Masseanschluss des Mikrocontrollers mit dem siebten Knoten verbunden. Außerdem sind ein Widerstand und eine Diode zwischen dem siebten Knoten und dem zweiten Knoten in Reihe geschaltet. Vorteilhafterweise kann die Schaltungsanordnung dann am dritten Knoten eine Versorgungsgleichspannung für nachfolgende Schaltungsteile bereitstellen.

In einer zusätzlichen Weiterbildung der Schaltungsanordnung sind zwischen dem dritten Knoten und dem zweiten Knoten ein Triac und ein Elektromotor in Reihe geschaltet. Dabei ist der Mikrocontroller ausgebildet, den Triac zu schalten. Vorteilhafterweise können der Mikrocontroller und der Triac den Elektromotor dann mittels einer Phasenanschnittssteuerung zur Leistungsregelung oder-steuerung ansteuern.

Ein erfindungsgemäßes Elektrogerät weist eine Schaltungsanordnung der vorgenannten Art auf. Vorteilhafterweise kann das Elektrogerät dann eine Schalterstellung eines Schalters erkennen, ohne hierfür zusätzliche Bauteile aufweisen zu müssen.

Ein erfindungsgemäßes Verfahren zum Erkennen einer Schalterstellung weist Schritte auf zum Ermitteln eines Verhältnisses zwischen einem Spannungswert und einer Referenzspannung, zum Erkennen, dass der Schalter geöffnet ist, falls das Verhältnis einen festgelegten Schwellwert unterschreitet, und zum Erkennen, dass der Schalter geschlossen ist, falls das Verhältnis den festgelegten Schwellwert nicht unterschreitet. Vorteilhafterweise kann das Verfahren durch einen Mikrocontroller ausgeführt werden.

In einer Weiterbildung des Verfahrens wird das Verhältnis durch Digitalisieren des Spannungswerts ermittelt, wobei die Referenzspannung als Bezugswert für die Digitalisierung dient. Vorteilhafterweise kann das digitale Signal dann leicht weiterverarbeitet werden.

In einer zweckmäßigen Ausführungsform des Verfahrens wird der Spannungswert mittels eines Spannungsversorgungsanschlusses eines Mikrocontrollers erfasst. Vorteilhafterweise sind zur Durchführung des Verfahrens neben dem Mikrocontroller dann keine weiteren elektronischen Bauelemente erforderlich.

Die Erfindung wird nun anhand der beigefügten Figur näher erläutert. Dabei zeigt:

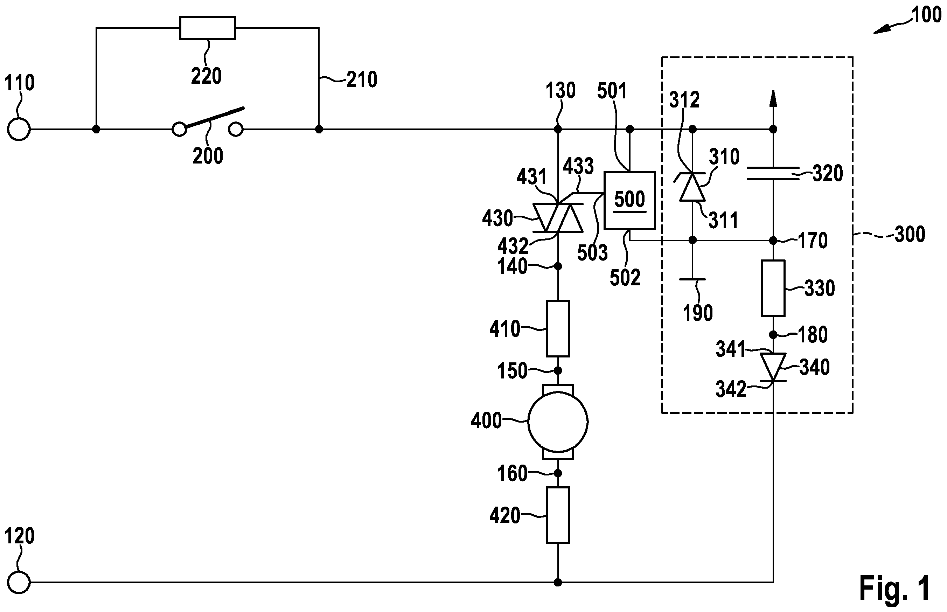

Figur 1 eine Schaltungsanordnung zum Erkennen einer Schalterstellung.

Figur 1 zeigt ein Schaltbild einer Schaltungsanordnung 100. Die Schaltungsanordnung 100 kann beispielsweise in einem elektrischen Gerät verwendet werden, um eine Schalterstellung eines Schalters des elektrischen Geräts zu erkennen. Das elektrische Gerät kann beispielsweise ein Elektrowerkzeug, beispielsweise eine Bohrmaschine oder ein Winkelschleifer, sein.

Die Schaltungsanordnung 100 weist einen ersten Schaltungsknoten 110 und einen zweiten Schaltungsknoten 120 auf. Die Knoten 110, 120 sind dazu vorgesehen, mit einem Wechselstromnetz verbunden zu werden. Dabei wird der erste Knoten 110 mit einer Phase (L) des Stromnetzes und der zweite Knoten 120 mit einem Neutralleiter (N) des Wechselstromnetzes verbunden, oder umgekehrt.

Zwischen dem ersten Knoten 110 der Schaltungsanordnung 100 und einem nachfolgenden dritten Knoten 130 der Schaltungsanordnung 100 ist ein Schalter 200 angeordnet. Der Schalter 200 kann geschlossen werden, um den ersten Knoten 110 leitend mit dem dritten Knoten 130 zu verbinden. Der Schalter 200 kann geöffnet werden, um eine direkte Verbindung zwischen dem ersten Knoten 110 und dem dritten Knoten 130 zu unterbrechen. Der Schalter 200 kann beispielsweise ein Netzschalter eines Elektrogeräts sein, in dem die Schaltungsanordnung 100 vorgesehen ist.

Dem Schalter 200 ist eine Stand-By-Leitung 210 parallel geschaltet, in der ein Stand-By-Widerstand 220 angeordnet ist. Die Stand-By-Leitung 210 mit dem Stand-By-Widerstand 220 ist somit ebenfalls zwischen dem ersten Knoten 110 und dem dritten Knoten 130 angeordnet. Die Stand-By-Leitung 210 dient dazu, die Elektronik, in dem die Schaltungsanordnung 100 angeordnet ist, auch in ausgeschaltetem Zustand, also bei geöffnetem Schalter 200, mit elektrischer Spannung zu versorgen. Eine solche Spannungsversorgung auch in ausgeschaltetem Zustand ist bei vielen Elektrogerät mit dauerversorgter Elektronik notwendig. Der Stand-By-Widerstand 220 kann dazu dienen, einen Stromfluss in ausgeschaltetem Zustand des Elektrogeräts zu begrenzen. Der in der Stand-By-Leitung 210 angeordnete Stand-By-Widerstand 220 dient außerdem dazu, die Schalterstellung des Schalters 200 zu detektieren, wie unten erläutert wird.

Auch zwischen dem zweiten Knoten 120 und nachfolgenden Schaltungsteilen der Schaltungsanordnung 100 kann ein Schalter angeordnet sein. Ein zwischen dem zweiten Knoten 120 und nachfolgenden Schaltungsteilen angeordneter Schalter kann derart mit dem Schalter 200 gekoppelt sein, dass beide Schalter stets eine einheitliche Schalterstellung aufweisen. Ein zwischen dem zweiten Knoten 120 und nachfolgenden Schaltungsteilen der Schaltungsanordnung 100 angeordneter Schalter kann jedoch, wie im in Figur 1 dargestellten Beispiel, entfallen.

Die Schaltungsanordnung 100 weist ein Netzteil 300 auf, das dazu dient, eine Versorgungsgleichspannung am dritten Knoten 130 zu generieren. Diese Versorgungsgleichspannung kann von einem Elektrogerät, in dem die Schaltungsanordnung 100 angeordnet ist, zur Versorgung anderer Schaltungen und Bauteile genutzt werden.

Das Netzteil 300 weist einen siebten Schaltungsknoten 170 auf, der mit einem Massepotential 190 verbunden ist. Zwischen dem dritten Knoten 130 und dem siebten Knoten 170 ist eine Zenerdiode 310 angeordnet. Dabei ist die Anode 311 der Zenerdiode 310 mit dem siebten Knoten 170 verbunden. Die Kathode 312 der Zenerdiode 310 ist mit dem dritten Knoten 130 verbunden. Weiter ist zwischen dem dritten Knoten 130 und dem siebten Knoten 170 ein Kondensator 320 angeordnet. Der Kondensator 320 ist der Zenerdiode 310 also parallel geschaltet. Der Kondensator 320 kann beispielsweise ein Elektrolytkondensator (ELKO) sein. Zwischen dem siebten Knoten 170 und dem zweiten Knoten 120 ist außerdem eine Reihenschaltung aus einem Widerstand 330 und einer Diode 340 angeordnet. Dabei ist eine Anode 341 der Diode 340 in Richtung des siebten Knotens 170 orientiert, während eine Kathode 342 der Diode 340 zum zweiten Knoten 120 hin orientiert ist. Im in Figur 1 dargestellten Ausführungsbeispiel ist der Widerstand 330 zwischen dem siebten Knoten 170 und einem achten Knoten 180 angeordnet. Die Diode 340 ist zwischen dem achten Knoten 180 und dem zweiten Knoten 120 angeordnet. Die Reihenfolge von Widerstand 330 und Diode 340 könnte jedoch auch vertauscht sein.

Die Diode 340 des Netzteils 300 bewirkt, dass der Kondensator 320 lediglich während einer Halbwelle einer zwischen dem ersten Knoten 110 und dem zweiten Knoten 120 anliegenden Wechselspannung aufgeladen wird. Während jeder zweiten Halbwelle der zwischen erstem Knoten 110 und zweitem Knoten 120 anliegenden Wechselspannung sperrt die Diode 340. Der Widerstand 330 wirkt als Strombegrenzung. Die Zenerdiode 310 begrenzt die maximale elektrische Spannung, auf die der Kondensator 320 aufgeladen wird. Die Durchbruchsspannung der Zenerdiode 310 kann hierzu beispielsweise 5,1 V betragen.

Im in Figur 1 dargestellten Beispiel umfasst die Schaltungsanordnung 100 außerdem einen Elektromotor 400, der mittels eines Triac 430 angesteuert werden kann. Der Elektromotor 400 kann ein Elektromotor eines Elektrogeräts, beispielsweise einer Bohrmaschine, sein. Der Triac 430 und der Elektromotor 400 sind in Reihe geschaltet. Im in Figur 1 gezeigten Beispiel ist der Triac 430 zwischen dem dritten Knoten 130 und einem vierten Knoten 140 der Schaltungsanordnung angeordnet. Dabei ist eine erste Elektrode 431 des Triacs 430 mit dem dritten Knoten 130 verbunden. Eine zweite Elektrode 432 des Triacs 430 ist mit dem vierten Knoten 140 verbunden. Zwischen dem vierten Knoten 140 und dem zweiten Knoten 120 ist der Elektromotor 400 angeordnet. In Figur 1 ist eine Reihenschaltung aus dem Elektromotor 400, einer ersten Spule 410 und einer zweiten Spule 420 dargestellt. Dabei ist die erste Spule 410 zwischen dem vierten Knoten 140 und einem fünften Knoten 150 der Schaltungsanordnung 100 angeordnet. Der Elektromotor 400 ist zwischen dem fünften Knoten 150 und einem sechsten Knoten 160 der Schaltungsanordnung 100 angeordnet. Die zweite Spule 420 ist zwischen dem sechsten Knoten 160 und dem zweiten Knoten 120 angeordnet.

Die Schaltungsanordnung 100 umfasst außerdem einen Mikrocontroller 500. Im in Figur 1 gezeigten Beispiel weist der Mikrocontroller 500 einen Anschluss 501, einen Masseanschluss 502 und einen Steueranschluss 503 auf. Der Masseanschluss 502 ist mit dem siebten Knoten 170 und damit mit dem Massepotential 190 verbunden. Der Steueranschluss 503 ist mit einer Steuerelektrode 433 des Triac 430 verbunden. Der Anschluss 501 ist mit dem dritten Knoten 130 der Schaltungsanordnung 100 verbunden.

Der Mikrocontroller 500 kann über den Steueranschluss 503 und die Steuerelektrode 433 des Triac 430 den Triac 430 in einen leitenden Zustand zwischen der ersten Elektrode 431 und der zweiten Elektrode 432 schalten. Dies nutzt der Mikrocontroller 500, um den Elektromotor 400 mittels einer Phasenanschnittssteuerung anzusteuern und die Leistung des Elektromotors 400 zu regeln oder zu steuern.

Der Anschluss 501 des Mikrocontrollers 500 ist bevorzugt ein Spannungsversorgungsanschluss des Mikrocontrollers 500. Somit wird der Mikrocontroller 500 über den Anschluss 501 mit Energie versorgt. Erfindungsgemäß erkennt der Mikrocontroller 500 über die an seinem Anschluss 501 anliegende elektrische Spannung auch, ob der Schalter 200 geöffnet oder geschlossen ist.

Ist der Schalter 200 der Schaltungsanordnung 100 geöffnet, so fällt ein Teil der am ersten Knoten 110 der Schaltungsanordnung 100 anliegenden elektrischen Spannung über dem Stand-By-Widerstand 220 ab. Daraus ergibt sich, dass die am dritten Knoten 130 der Schaltungsanordnung 100 anliegende Spannung geringer als die am ersten Knoten 110 der Schaltungsanordnung 100 anliegende Spannung ist. Ist der Schalter 200 der Schaltungsanordnung 100 jedoch geschlossen, so ist der Stand-By-Widerstand 220 kurzgeschlossen, so dass praktisch keine Spannung über den Stand-By-Widerstand 220 abfällt. In diesem Fall entspricht die am dritten Knoten 130 anliegende elektrische Spannung weitgehend der am ersten Knoten 110 der Schaltungsanordnung 100 anliegenden elektrischen Spannung und ist größer als die bei geöffnetem Schalter 200 am dritten Knoten 130 anliegende elektrische Spannung.

Der Mikrocontroller 500 verfügt über eine interne Referenzspannung. Außerdem verfügt der Mikrocontroller 500 über die Möglichkeit, den Spannungswert der an seinem Anschluss 501 anliegenden elektrischen Spannung mittels eines Analog-Digital-Wandlers zu digitalisieren und die interne Referenzspannung des Mikro-controllers 500 dabei als Bezugswert zu verwenden. Ein solches Vorgehen ist beispielsweise in der Druckschrift "Application Note AN 1072" von Microchip beschrieben. Der durch den Analog-Digital-Wandler des Mikrocontrollers 500 gelieferte Digitalwert gibt dann ein Verhältnis der Größe der am Anschluss 501 des Mikrocontrollers 500 anliegenden Spannung zur Größe der Referenzspannung an. Der tatsächliche Wert der Referenzspannung ist dabei unerheblich, solange die Referenzspannung konstant, kleiner als die am Anschluss 501 anliegende Spannung und größer als das Massepotential ist.

Der durch den Analog-Digital-Wandler des Mikrocontrollers 500 gelieferte Digitalwert weist unterschiedliche Werte auf, je nachdem, ob der Schalter 200 geöffnet oder geschlossen ist. Ist der Schalter 200 geschlossen, so ist das Verhältnis zwischen der Spannung am Anschluss 501 und der Referenzspannung des Mikrocontrollers 500 größer und der Digitalwert weist einen hohen Wert auf. Ist der Schalter 200 geöffnet, so ist das Verhältnis zwischen der am Anschluss 501 des Mikrocontrollers 500 anliegenden Spannung zur Referenzspannung des Mikro-controllers 500 niedriger und der Digitalwert weist einen kleineren Wert auf. Der Mikrocontroller 500 vergleicht den Digitalwert mit einem im Mikrocontroller 500 hinterlegten Schwellwert. Liegt der Digitalwert unterhalb des festgelegten Schwellwerts, so schließt der Mikrocontroller 500 daraus, dass der Schalter 200 geöffnet ist. Andernfalls schlussfolgert der Mikrocontroller 500, dass der Schalter 200 geschlossen ist.

Ein besonderer Vorteil der Schaltungsanordnung 100 besteht darin, dass zum Erkennen der Stellung des Schalters 200 keine zusätzlichen Bauteile und keine zusätzlichen Anschlüsse des Mikrocontrollers 500 benötigt werden. Alle Bauteile der Schaltungsanordnung 100 sind auch ohne Möglichkeit einer Erkennung der Stellung des Schalters 200 zum Betrieb eines Elektrogeräts, das die Schaltungsanordnung 100 aufweist, erforderlich. Der Anschluss 501 des Mikrocontrollers 500 muss ohnehin mit dem dritten Knoten 130 der Schaltungsanordnung 100 verbunden sein, um den Mikrocontroller 500 mit elektrischer Spannung zu versorgen. Erfindungsgemäß kann alleine durch geeignete Programmierung des Mikrocontrollers 500 zusätzlich die Stellung des Schalters 200 erkannt werden.

Der Mikrocontroller 500 kann die Kenntnis der Stellung des Schalters 200 beispielsweise zur Realisierung eines Wiederanlaufschutzes eines Elektrogeräts nutzen, in dem die Schaltungsanordnung 100 vorgesehen ist.

## Patentansprüche

1. Schaltungsanordnung (100) zum Erkennen einer Schalterstellung,
mit einem ersten Knoten (110), der mit einer Phase eines Stromnetzes verbunden werden kann,
einem dritten Knoten (130)
und einem Mikrocontroller (500),
wobei zwischen dem ersten Knoten (110) und dem dritten Knoten (130) ein Schalter (200) angeordnet ist,
wobei ein Widerstand (220) parallel zu dem Schalter (200) zwischen dem ersten Knoten (110) und dem dritten Knoten (130) angeordnet ist,
wobei ein Anschluss (501) des Mikrocontrollers (500) mit dem dritten Knoten (130) verbunden ist,
wobei der Anschluss (501) ein Spannungsversorgungsanschluss des Mikrocontrollers (500) ist,
wobei der Mikrocontroller (500) programmiert ist, eine an dem Anschluss (501) anliegende Spannung mit einer Referenzspannung zu vergleichen, und anhand dieses Vergleichs festzustellen, ob der Schalter (200) geöffnet oder geschlossen ist.

2. Schaltungsanordnung (100) gemäß Anspruch 1,
wobei der Mikrocontroller (500) einen Analog-Digital-Wandler aufweist, wobei die Referenzspannung als Bezugswert des Analog-Digital-Wandlers dient,
wobei der Mikrocontroller (500) programmiert ist, die an dem Anschluss (501) anliegende Spannung mittels des Analog-Digital-Wandlers zu digitalisieren, um einen Digitalwert zu erhalten,
wobei der Mikrocontroller (500) ferner programmiert ist, anhand des Digitalwerts festzustellen, ob der Schalter (200) geöffnet oder geschlossen ist.

3. Schaltungsanordnung (100) gemäß einem der vorhergehenden Ansprüche, wobei die Referenzspannung eine interne Referenzspannung des Mikrocontrollers (500) ist.

4. Schaltungsanordnung (100) gemäß einem der vorhergehenden Ansprüche, wobei die Schaltungsanordnung (100) einen zweiten Knoten (120) aufweist, der mit einem Neutralleiter eines Stromnetzes verbunden werden kann, wobei die Schaltungsanordnung (100) einen siebten Knoten (170) aufweist, der mit einem Massepotential (190) verbunden ist,
wobei eine Anode (311) einer Zener-Diode (310) mit dem siebten Knoten (170) und eine Kathode (312) der Zener-Diode (310) mit dem dritten Knoten (130) verbunden ist,
wobei ein Kondensator (320) zwischen dem dritten Knoten (130) und dem siebten Knoten (170) angeordnet ist,
wobei ein Masseanschluss (502) des Mikrocontrollers (500) mit dem siebten Knoten (170) verbunden ist,
wobei ein Widerstand (330) und eine Diode (340) zwischen dem siebten Knoten (170) und dem zweiten Knoten (120) in Reihe geschaltet sind.

5. Schaltungsanordnung (100) gemäß Anspruch 4,
wobei zwischen dem dritten Knoten (130) und dem zweiten Knoten (120) ein Triac (430) und ein Elektromotor (400) in Reihe geschaltet sind,
wobei der Mikrocontroller (500) ausgebildet ist, den Triac (430) zu schalten.

6. Elektrogerät mit einer Schaltungsanordnung (100) gemäß einem der vorhergehenden Ansprüche.

## Claims

1. Circuit arrangement (100) for detecting a switch position,
having a first node (110), which can be connected to a phase of an electrical grid,
a third node (130),
and a microcontroller (500),
wherein a switch (200) is arranged between the first node (110) and the third node (130),
wherein a resistor (220) is arranged in parallel with the switch (200) between the first node (110) and the third node (130),
wherein a connection (501) of the microcontroller (500) is connected to the third node (130), wherein the connection (501) is a voltage supply connection of the microcontroller (500),
wherein the microcontroller (500) is programmed to compare a voltage present at the connection (501) with a reference voltage and, on the basis of said comparison, to determine whether the switch (200) is open or closed.

2. Circuit arrangement (100) according to Claim 1, wherein the microcontroller (500) has an analog-to-digital converter,
wherein the reference voltage is used as reference value for the analog-to-digital converter,
wherein the microcontroller (500) is programmed to digitize the voltage present at the connection (501) by means of the analog-to-digital converter in order to obtain a digital value,
wherein the microcontroller (500) is also programmed to determine, on the basis of the digital value, whether the switch (200) is open or closed.

3. Circuit arrangement (100) according to either of the preceding claims,
wherein the reference voltage is an internal reference voltage of the microcontroller (500).

4. Circuit arrangement (100) according to one of the preceding claims,
wherein the circuit arrangement (100) has a second node (120), which can be connected to a neutral conductor of an electrical grid,
wherein the circuit arrangement (100) has a seventh node (170), which is connected to a ground potential (190),
wherein an anode (311) of a Zener diode (310) is connected to the seventh node (170) and a cathode (312) of the Zener diode (310) is connected to the third node (130),
wherein a capacitor (320) is arranged between the third node (130) and the seventh node (170),
wherein a ground connection (502) of the microcontroller (500) is connected to the seventh node (170),
wherein a resistor (330) and a diode (340) are connected in series between the seventh node (170) and the second node (120).

5. Circuit arrangement (100) according to Claim 4, wherein a triac (430) and an electric motor (400) are connected in series between the third node (130) and the second node (120),
wherein the microcontroller (500) is designed to switch the triac (430).

6. Electrical apparatus having a circuit arrangement (100) according to one of the preceding claims.

## Revendications

1. Arrangement de circuit (100) destiné à détecter une position de commutateur,
comprenant un premier noeud (110) qui peut être relié à une phase d'un réseau électrique,
un troisième noeud (130),
et un microcontrôleur (500),
un commutateur (200) étant disposé entre le premier noeud (110) et le troisième noeud (130),
une résistance (220) étant montée en parallèle avec le commutateur (200) entre le premier noeud (110) et le troisième noeud (130),
une borne (501) du microcontrôleur (500) étant reliée au troisième noeud (130),
la borne (501) étant une borne d'alimentation électrique du microcontrôleur (500),
le microcontrôleur (500) étant programmé pour comparer une tension appliquée à la borne (501) avec une tension de référence et déterminer, à l'aide de cette comparaison, si le commutateur (200) est ouvert ou fermé.

2. Arrangement de circuit (100) selon la revendication 1,
le microcontrôleur (500) possédant un convertisseur analogique/numérique,
la tension de référence servant de valeur de référence du convertisseur analogique/numérique,
le microcontrôleur (500) étant programmé pour numériser la tension appliquée à la borne (501) au moyen du convertisseur analogique/numérique afin d'obtenir une valeur numérique,
le microcontrôleur (500) étant en outre programmé pour déterminer, au moyen de la valeur numérique, si le commutateur (200) est ouvert ou fermé.

3. Arrangement de circuit (100) selon l'une des revendications précédentes, la tension de référence étant une tension de référence interne du microcontrôleur (500).

4. Arrangement de circuit (100) selon l'une des revendications précédentes,
l'arrangement de circuit (100) possédant un deuxième noeud (120) qui peut être relié à un conducteur neutre d'un réseau électrique,
l'arrangement de circuit (100) possédant un septième noeud (170) qui est relié à un potentiel de masse (190), une anode (311) d'une diode Zener (310) étant reliée au septième noeud (170) et une cathode (312) de la diode Zener (310) au troisième noeud (130),
un condensateur (320) étant disposé entre le troisième noeud (130) et le septième noeud (170),
une borne de masse (502) du microcontrôleur (500) étant reliée au septième noeud (170),
une résistance (330) et une diode (340) étant branchées en série entre le septième noeud (170) et le deuxième noeud (120).

5. Arrangement de circuit (100) selon la revendication 4, un triac (430) et un moteur électrique (400) étant branchés en série entre le troisième noeud (130) et le deuxième noeud (120), le microcontrôleur (500) étant configuré pour faire commuter le triac (430).

6. Appareil électrique comprenant un arrangement de circuit (100) selon l'une des revendications précédentes.
